# EUROPÄISCHE PATENTSCHRIFT

(11) **EP 3 112 935 B1**
(45) Veröffentlichungstag und Bekanntmachung des Hinweises auf die Patenterteilung: **05.05.2021**
(21) Anmeldenummer: 16170660.1
(22) Anmeldetag: 20.08.2009
(51) Int. Cl.: G03F 7/16, H01L 21/768, G03F 7/095

(54) **VERFAHREN ZUR RESIST-BESCHICHTUNG EINER VERTIEFUNG IN DER OBERFLÄCHE EINES SUBSTRATS, INSBESONDERE EINES WAFERS**
PROCESS FOR REALISING A RESIST COATING IN A RECESS ON THE SURFACE OF A SUBSTRATE, IN PARTICULAR A WAFER
PROCÉDÉ POUR DÉPOSER UN RÉSISTE DANS DES CREUX À LA SURFACE D'UN SUBSTRAT, EN PARTICULIER D'UN WAFER

(30) Priorität: 29.08.2008 DE 102008045068
(43) Veröffentlichungstag der Anmeldung: 04.01.2017
(62) Teilanmeldung aus: 09782047.6
(73) Patentinhaber: Suss MicroTec Lithography GmbH, 85748 Garching (DE)
(72) Erfinder: WEILERMANN, Katrin, 85748 Garching (DE)
(74) Vertreter: Prinz & Partner mbB

(56) Entgegenhaltungen:
- EP-A2- 0 157 675
- JP-A- 8 250 397
- JP-A- 10 056 261
- JP-A- H05 243 729
- JP-A- 2001 196 722
- JP-A- 2002 368 415
- JP-B1- 2 954 163
- US-A- 5 849 435
- US-A- 5 858 475
- US-A- 5 925 410

## Beschreibung

Die Erfindung betrifft ein Verfahren zur Resist-Beschichtung einer Vertiefung, z. B. eines VIA ("vertical interconnect access")-Lochs oder eines Sacklochs, in der Oberfläche eines Substrats, z. B. eines Wafers.

Die Beschichtung mit einem Resist, z. B. Lack oder dielektrische Schicht, ist beispielsweise für die Verdrahtung und Ankopplung von MEMS ("micro-electromechanical system")-Vorrichtungen wichtig. Kontaktierungen dieser Vorrichtungen über Vertiefungen wie VIA-Löcher sind vorteilhaft, um immer kleiner werdende Verkapselungen von MEMS-Vorrichtungen (wie Sensoren, Speicher, elektronische oder mikromechanische Bausteine) zu erreichen.

Beschichtungen von Substraten sind z. B. bekannt aus Kutchoukov, V.G., Mollinger, J.R., Bossche, A.: "New photoresist coating method for 3-D structured wafers" in Sensors and Actuators A, 2000, Band 85, Seiten 377-383; Pham, Nga P., Burghartz, Joachim N., Sarro, Pasqualina M.: "Spray coating of photoresist for pattern transfer on high topography surfaces" in Journal of Micromechanics and Microengineering, 2005, Band 15, Seiten 691-697; US-A-5 849 435; EP-A-1 840 940; und JP-A-2008-55268.

Um möglichst genaue Kontaktierungen an der Oberfläche eines Substrats, z. B. eines Wafers, zu erlangen, ist es vorteilhaft, eine gleichmäßige Lackschicht, z. B. aus einem Fotolack, auf der Innenfläche der Vertiefung des Substrats aufzubringen. Bei Vertiefungen mit einem großen Verhältnis von Tiefe/Breite (bzw. kleinem Durchmesser) der Vertiefung ist es besonders schwierig, z. B. durch Sprühbeschichtung die Wände der Vertiefung ganzflächig zu bedecken.

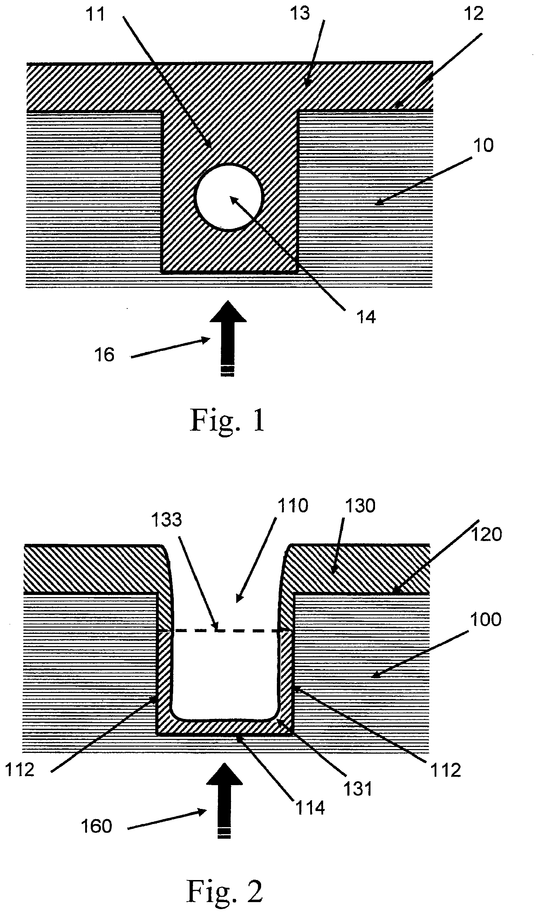

Eine Möglichkeit, eine Vertiefung eines Substrats zu beschichten, besteht darin, eine Resist-Lösung in einem Schritt sowohl auf die Oberfläche des Substrats aufzubringen als auch in die Vertiefung zu füllen. Von dem Resist eingeschlossene Luft in der Vertiefung wird dann mit Hilfe von z. B. Ultraschall aus der Vertiefung entfernt (siehe z. B. Fig. 1).

Aus der US 5,849,435 A ist es bekannt, eine Vertiefung eines Substrats direkt mit einem Resist-Material (Fotolack) zu beschichten, wobei das beschichte Substrat mechanischen Vibrationen ausgesetzt wird, um das Resist-Material zu verteilen.

Die JP 2002-368415 A sowie die JP 2954163 B1 zeigen jeweils ein Substrat, welches zweimal mit einem Resist-Material beschichtet worden ist.

Mit herkömmlichen Verfahren ist es schwierig, auf der Innenfläche einer Vertiefung an einer Oberfläche eines Substrats eine gleichmäßige Resist-Schicht ganzflächig herzustellen.

Daher ist es Aufgabe der Erfindung, ein verbessertes Verfahren zur Resist-Beschichtung der Innenfläche einer Vertiefung an der Oberfläche eines Substrats zur Verfügung zu stellen.

Diese Aufgabe wird erfindungsgemäß mit einem Verfahren gemäß Anspruch 1 gelöst.

Bei dem erfindungsgemäßen Verfahren wird unter anderem in einem ersten Verfahrensschritt (a) die Vertiefung an der Oberfläche eines Substrats mit einer Resist-Lösung befüllt und in einem zweiten Verfahrensschritt (b) das Substrat derart erwärmt, dass das Lösungsmittel der Resist-Lösung verdampft und der Boden und zumindest Abschnitte der Innenwände der Vertiefung, die an den Boden grenzen, mit dem Resist beschichtet sind. Vorzugsweise sind die Innenwände nach dem Verdampfungsprozess teilweise oder ganz mit dem Resist beschichtet.

Eine Vertiefung an der Oberfläche eines Substrats kann z. B. ein VIA-Loch sein und weist eine Innenfläche aus Innenwänden auf, die beschichtet werden sollen. Diese Innenwände können Boden- und/oder Seitenwände der Vertiefung sein. In einer besonderen Ausführungsform weist die Vertiefung eine Bodenwand ("Boden") auf, die sich parallel zur Oberfläche des Substrats erstreckt. In einer weiteren Ausführungsform weist die Vertiefung neben diesem Boden mindestens eine, sich senkrecht zu ihm erstreckende Seitenwand auf. Der Querschnitt parallel zur Oberfläche einer solchen Vertiefung ist vorzugsweise eine Ellipse, insbesondere ein Kreis, oder ein Rechteck, insbesondere ein Quadrat, oder jedes mögliche Vieleck, und kann über die gesamte Tiefe der Vertiefung konstant sein. Die Neigung der Seitenwände der Vertiefung gegenüber dem Boden der Vertiefung bzw. gegenüber der Oberfläche des Substrats kann zwischen 50° und 100°, vorzugsweise bei 90° liegen.

Eine Resist-Lösung enthält im Wesentlichen einen Resist und ein Lösungsmittel für den Resist. Ein Resist kann z. B. ein Lack oder Fotolack, ein positiver Novolack oder ein Dielektrikum sein, z. B. BCB oder SU-8, oder ein Fotolack der Firma Microchem Corp., wobei als Lösungsmittel Mesitylen oder PGMEA verwendet werden kann.

Das Erwärmen des Substrats kann z. B. bei Temperaturen von 30 bis 90°C, vorzugsweise von 50 bis 90°C, stattfinden. Die Temperaturerhöhungen können z. B. durch eine oder mehrere Infrarot-Strahlungsquellen oder eine elektrische Heizung erzeugt werden, die z. B. die Unterseite des Substrats direkt berührt oder in einem Abstand von 1-20 cm von der Oberfläche des Substrats entfernt angeordnet ist.

Durch das Erwärmen verdampft das Lösungsmittel in der Resist-Lösung. Vorzugsweise lagert sich hierbei aufgrund von Adhäsionskräften der Resist als im Wesentlichen durchgängige Schicht an dem Boden und zumindest an den Teilen der Innenwände der Vertiefung ab, die an den Boden grenzen. Vorzugsweise sind sämtliche Innenwände der Vertiefung nach dem Erwärmen des Substrats komplett mit dem Resist beschichtet. In diesem Fall existieren keine Abschnitte von Innenwänden, die nicht mit Resist beschichtet sind.

Erfindungsgemäß wird nach dem Schritt (b) in einem weiteren Verfahrensschritt (c) die Oberfläche des Substrats mit einem Resist derart beschichtet, dass Resist-Lösung von der Oberfläche in die Vertiefung überfließt, sodass auch Abschnitte von Innenwänden der Vertiefung, die an die Oberfläche des Substrats grenzen und nach den Verfahrensschritten (a) und (b) noch nicht beschichtet sind, ebenfalls beschichtet werden. Durch diese Beschichtung der Oberfläche des Substrats kann erreicht werden, dass auch in den Fällen, in denen nach den Schritten (a) und (b) die Innenwände der Vertiefung nicht komplett mit Resist beschichtet wurden (wie z. B. bei Abschnitten, die am weitesten vom Boden entfernt sind), diese zumindest nach dem Schritt (c) eine Resist-Schicht aufweisen. In diesem Fall kann eine durchgängige Resist-Schicht an den Innenwänden der Vertiefung und an der Oberfläche des Substrats vorliegen.

Die Breite der Vertiefung beträgt erfindungsgemäß 10 bis 100 µm.

In einer bevorzugten Ausführungsform der vorliegenden Erfindung geschieht das Beschichten der Oberfläche des Substrats mit dem Resist durch Aufbringen einer Resist-Lösung. Diese Resist-Lösung wird vorzugsweise durch Sprühbeschichtung auf die Oberfläche aufgetragen. In einer besonderen Ausführungsform ist die Viskosität dieser Lösung gleich oder höher als die Viskosität der Resist-Lösung zum Befüllen der Vertiefung. Die Viskositäten von Resist-Lösungen können in einem Bereich von > 0 Millipascalsekunden bis 200 Millipascalsekunden liegen.

In einer bevorzugten Ausführungsform findet ein erstes Befüllen der Vertiefung in Schritt (a) gleichzeitig mit einem Beschichten der Oberfläche des Substrats mit der Resist-Lösung statt.

Hierdurch kann erreicht werden, dass in einem einzigen Verfahrensschritt, vorzugsweise mit einer einzigen Sprühdüse, die Resist-Lösung sowohl auf die Oberfläche des Substrats aufgebracht als auch in die Vertiefung an der Oberfläche des Substrats gefüllt wird. Das anschließende Erwärmen des Substrats lässt dann das Lösungsmittel verdampfen, so dass eine durchgängige Resist-Schicht auf der Oberfläche und eine abschnittweise Beschichtung in der Vertiefung zurückbleiben kann.

In einer bevorzugten Ausführungsform ist das Erwärmen des Substrats ein Erwärmen der Vertiefung und/oder der Oberfläche. Durch das Erwärmen von Abschnitten nahe der aufgebrachten oder eingefüllten Resist-Lösung wird das Lösungsmittel erwärmt und verdampft, so dass eine Resist-Schicht an den Innenwänden der Vertiefung und/oder an der Oberfläche des Substrats zurückbleibt.

In einer bevorzugten Ausführungsform bildet der Resist nach den Schritten (a), (b) und gegebenenfalls (c) auf den Innenwänden der Vertiefung eine durchgängige Schicht.

Eine durchgängige Schicht auf einer Fläche weist keine Abschnitte auf, an denen die Fläche nicht beschichtet ist. Die durchgängige Resist-Schicht auf der Oberfläche des Substrats und/oder in der Vertiefung (an den Innenwänden der Vertiefung) ist vorteilhaft für die spätere Weiterverarbeitung des Substrats, z. B. bei einem Belichten, Entwickeln und Ätzen für eine spätere Kontaktierung auf diesen Flächen.

In einer bevorzugten Ausführungsform geschieht das Befüllen der Vertiefung des Substrats durch eine Sprühbeschichtung.

Eine Sprühbeschichtung ("spray-coating") ist besonders vorteilhaft für diese Zwecke, da mit ihr ein sehr gleichmäßiges Auftragen der Resist-Lösung möglich ist. Dadurch können Unebenheiten an der Oberfläche des Substrats und an den Innenwänden der Vertiefung im Wesentlichen vermieden/ausgeglichen werden.

In einem bevorzugten Verfahren ist das Volumen der eingefüllten Resist-Lösung gleich groß oder geringer als das Volumen der Vertiefung.

In einer bevorzugten Ausführungsform ist die Vertiefung ein Durchgangsloch, vorzugsweise ein VIA-Loch, durch das Substrat. Das Substrat weist zudem an seiner Unterseite, die seiner Oberfläche gegenüberliegt, einen Träger auf, welcher das Durchgangsloch an dieser Seite als Boden verschließt. Es kann vorteilhaft sein, dass das Durchgangsloch mindestens eine senkrecht zur Substratoberfläche stehende Seitenwand hat. In einer besonderen Ausführungsform kann zumindest eine Seitenwand eine Neigung, von z. B. 70° gegenüber der Substratoberfläche, aufweisen.

In einer besonders bevorzugten Ausführungsform umfasst das Verfahren nach den Schritten (a) und (b), gegebenenfalls nach den Schritten (a), (b) und (c), einen Schritt (d), in dem der Träger entfernt wird.

Der Träger kann an dem Substrat befestigt, z. B. angeklebt, sein. Mögliche Klebstoffe für diese Zwecke können z. B. Acrylate oder Epoxykleber sein. Vorzugsweise ist das Substrat leicht von dem Träger zu lösen, z. B. durch Verwendung von UV-Licht oder eines chemischen Lösungsmittels. Auf diese Weise können beschichtete Durchgangslöcher in einem Substrat bzw. Wafer hergestellt werden.

In einer bevorzugten Ausführungsform umfasst das Verfahren nach dem Schritt (d) einen Schritt (e), in dem die Unterseite des Substrats mit einem Resist derart beschichtet, vorzugsweise sprühbeschichtet, wird, dass auch Abschnitte von Innenwänden des Durchgangslochs, die der Unterseite des Substrats am nächsten liegen, beschichtet werden.

Durch diese Beschichtung der Unterseite des Substrats kann erreicht werden, dass auch in den Fällen, in denen nach Entfernung des Trägers die Innenwände des Durchgangslochs nicht komplett mit Resist beschichtet sind (z. B. hervorgerufen durch eine Beschädigung der Beschichtung an bodennahen Seitenwandabschnitten durch die Entfernung des Trägers/Bodens), diese zumindest nach dem Schritt (e) eine Resist-Schicht aufweisen. In diesem Fall kann z. B. eine durchgängige Resist-Schicht an den Innenwänden des Durchgangslochs und an der Oberfläche und der Unterseite des Substrats vorliegen. Vorzugsweise wird nach dem Schritt (e) das Substrat erwärmt, so dass noch vorhandene Lösungsmittel aus der Resist-Lösung verdampfen.

In einer bevorzugten Ausführungsform bildet nach den Schritten (a), (b), (d) und (e), gegebenenfalls nach den Schritten (a), (b), (c), (d) und (e), der Resist in dem Durchgangsloch und an der Oberfläche und der Unterseite des Substrats eine durchgängige Schicht. Dies kann z. B. bei einem Durchgangsloch als Vertiefung dadurch erreicht werden, dass erst auf die Oberseite des Substrats und dann auf die Unterseite des Substrats, oder umgekehrt, eine Resist-Lösung, vorzugsweise durch Sprühbeschichtung, aufgetragen wird. Alternativ können auch erst die Seitenwände des Durchgangslochs beschichtet werden, indem z. B. ein Träger an der Unterseite des Substrats derart befestigt ist, dass er das Durchgangsloch an dieser Seite flüssigkeitsdicht verschließt. Die Resist-Lösung wird dann in das Durchgangsloch eingefüllt, das Substrat wird erwärmt, und dann wird die Oberfläche des Substrats ebenfalls mit einem Resist beschichtet (als weitere Alternative können die Innenwände gleichzeitig mit der Oberfläche in einem Schritt beschichtet werden). Nach der Entfernung des Trägers/Bodens wird die Unterseite des Substrats mit dem Resist, vorzugsweise durch Sprühen, beschichtet.

Die z. B. auf diese Weisen hergestellte durchgängige Resist-Schicht an der Oberfläche, Unterseite und den Innenwänden des Durchgangslochs ist für eine spätere Kontaktierung in dem Loch von Vorteil, weil Defekte in dieser Schicht hierdurch vermieden werden können.

In einer bevorzugten Ausführungsform weist das Substrat auf seiner Oberfläche und in der Vertiefung eine Dielektrikum-Schicht auf, auf der die Resist-Beschichtung durchgeführt wird.

Die Dielektrikum-Schicht kann z. B. eine Oxidschicht sein.

Eine Dielektrikum-Schicht kann z. B. als Isolator dienen, wenn bei einer späteren Weiterbearbeitung des Substrats insbesondere eine Metall-Struktur (z. B. aus Aluminium) auf die Oberfläche des Substrats aufgebracht werden soll.

In einer bevorzugten Ausführungsform ist das Verhältnis der größten Tiefe der Vertiefung, senkrecht zur Substratoberfläche gemessen, zur größten Breite bzw. Durchmesser der Vertiefung, parallel zur Substratoberfläche gemessen, gleich 2:1 oder größer. Die größte Tiefe der Vertiefung, senkrecht zur Substratoberfläche gemessen, kann zwischen 20 µm und 300 µm, vorzugsweise zwischen 30 µm und 150 µm oder zwischen 40 µm und 70 µm, und die größte Breite der Vertiefung, parallel zur Substratoberfläche gemessen, beträgt 10 µm bis 100 µm.

In einer bevorzugten Ausführungsform ist die Dicke der Resist-Schicht in der Vertiefung des Substrats und vorzugsweise auch auf der Oberfläche und/oder der Unterseite des Substrats mindestens 0,5 µm, vorzugsweise mindestens 0,8 µm bzw. mindestens 1,0 µm. Derartige Resist-Schichtdicken können bei weiteren Verfahren, wie z. B. Belichten, Entwickeln und Ätzen, besonders genaue (scharfkantige) Oberflächen-Strukturen für die spätere Kontaktierung ermöglichen.

Erfindungsgemäß wird nach Schritt (a) ein Schritt (a1) durchgeführt, bei dem durch den Resist in der Vertiefung eingeschlossene Luft durch Anwendung von Ultraschall und/oder Stickstoff-Strom oder Vakuum entfernt wird.

Wie oben bereits erläutert kann durch die Anwendung von Ultraschall (z. B. durch Plazieren einer Ultraschallquelle unter dem Substrat) und/oder durch ein Vakuum von dem eingefüllten Resist eingeschlossene Luft aus der Vertiefung entfernt werden. Alternativ oder zusätzlich zu der Ultraschallquelle kann hierzu auch Stickstoff verwendet werden, der aus einer schräg zur Oberfläche des Substrats angesetzten Düse strömt. Durch das Entfernen von eingeschlossener Luft kann erreicht werden, dass auf der Innenfläche der Vertiefung eine gleichmäßige Resist-Schicht ganzflächig hergestellt wird.

In einer bevorzugten Ausführungsform wird Ultraschall mit einer Frequenz von 100 kHz bis 5 MHz, vorzugsweise von mehr als 400 kHz, beispielsweise zwischen 1 MHz und 3 MHz ("Megaschall") verwendet.

Erfindungsgemäß wird nach Schritt (a) und gegebenenfalls nach Schritt (a1) ein Schritt (a2) durchgeführt, bei dem die Oberfläche des Substrats durch Abschleudern gereinigt wird, insbesondere unter Verwendung der Resist-Lösung oder eines Lösungsmittels.

Um Verunreinigungen auf der Oberfläche auch für spätere Kontaktierungen zu vermeiden, kann es sinnvoll sein, die Oberfläche während der Beschichtung zu reinigen. Dies geschieht vorzugsweise mit der Resist-Lösung selbst oder unter Verwendung eines Lösungsmittels, welches die Oberfläche nicht beschädigt. Vorteilhafterweise geschieht die Reinigung derart, dass das Substrat rotiert wird, so dass die entsprechende Reinigungslösung auf die Oberfläche aufgebracht werden und von dieser zusammen mit eventuellen Verunreinigungen abgeschleudert werden kann.

In einer besonders bevorzugten Ausführungsform wird als Resist-Lösung eine Lösung aus AZ 4620 und Aceton (1-5 Millipascalsekunden) verwendet. Nach dem Befüllen der Vertiefung wird das Lösungsmittel Aceton aus der Resist-Lösung bei einer Temperatur von 30 bis 90°C mit Hilfe einer Heizplatte, die sich direkt unter dem Substrat befindet, über einen Zeitraum von 10 min verdampft. Die in der Vertiefung zurückbleibende Resist-Schicht ist in diesem Fall mindestens etwa 2 µm dick.

Die Erfindung wird im Folgenden mit Bezug auf die Figuren näher erläutert, die schematisch das Verfahren zur Resist-Beschichtung von Vertiefungen zeigen.
Figur 1 zeigt eine Seitenansicht eines Substrats mit einer Vertiefung zur Erläuterung eines herkömmlichen Beschichtungsverfahrens;
Figur 2 zeigt eine Seitenansicht eines Substrats mit einer Vertiefung, die mit einem Schritt des erfindungsgemäßen Verfahrens beschichtet wurde;
Figur 3 zeigt eine Seitenansicht eines Substrats mit einem Durchgangsloch, das auf einer Dielektrikum-Schicht mit dem erfindungsgemäßen Verfahren beschichtet wurde;
Figur 4 zeigt eine Seitenansicht des Substrats aus Figur 3 nach einer Weiterbehandlung, in der die Resist-Beschichtung entfernt und eine Metallschicht aufgebracht wurde.

Figur 1 zeigt beispielhaft ein herkömmliches Verfahren, wie ein Substrat 10, z. B. ein Wafer, mit einer Vertiefung 11 beschichtet werden kann. Hierzu wird eine Resist-Schicht 13 auf die Oberfläche 12 des Substrats 10 aufgebracht und dabei auch in die Vertiefung 11 gefüllt. Eventuell in der gerade aufgetragenen Resist-Lösung eingeschlossene Luftblasen 14 können dann z. B. mit Ultraschall 16 (und/oder Stickstoff-Strom aus einer Düse oder Vakuum) aus der Vertiefung 11 durch die Resist-Schicht 13 (nach oben) entfernt werden.

Anhand von Figur 2 wird beispielhaft ein erfindungsgemäßes Verfahren zur Beschichtung einer Vertiefung 110 an der Oberfläche 120 eines Substrats 100 beschrieben.

Eine Resist-Lösung wird in die Vertiefung 110 eingefüllt. Vorher, gleichzeitig oder nach dem Befüllen wird das Substrat 100 erwärmt (über eine Wärmequelle 160), so dass das Lösungsmittel in der Resist-Lösung verdampfen kann. Zurück bleibt eine Resist-Schicht 131 in der Vertiefung 110, die die Innenwände 112, 114, das sind die Seitenwände 112 und der Boden 114, bedeckt. Die Seitenwände 112 werden dabei an den Abschnitten bedeckt, die an den Boden 114 grenzen. Das heißt, dass nicht die kompletten Seitenwände 112 von der Resist-Schicht 131 bedeckt sind. Durch ein anschließendes Aufbringen einer Resist-Lösung auf die Oberfläche 120 des Substrats 100 wird erreicht, dass hierbei auch Abschnitte der Seitenwände 112 der Vertiefung 110, die der Oberfläche 120 am nächsten liegen (wie z. B. Abschnitte oberhalb der horizontalen Linie 133 in Figur 2), mit der Resist-Lösung bedeckt sind, und zwar durch das Überfließen der Resist-Lösung von der Oberfläche 120 des Substrats in die Vertiefung 110, zumindest entlang der oberen Seitenwände 112. Erneutes Erwärmen des Substrats 100 lässt das Lösungsmittel aus der Resist-Lösung verdampfen, so dass auch hier eine Resist-Schicht 130 zurückbleibt.

Auf diese Weise kann eine Vertiefung in einem Substrat mit einem Resist durchgängig und gleichmäßig (d. h. bis auf Eck- oder Kantenbereiche im Wesentlichen eben) beschichtet werden.

Alternativ ist es auch möglich, dass eine Resist-Lösung auf die Oberfläche 120 des Substrats 100 aufgebracht und gleichzeitig in die Vertiefung 110 eingefüllt wird. Nach dem Erwärmen des Substrats 100 durch eine Wärmequelle 160 sind dann der Boden 114 der Vertiefung 110 und die Oberfläche 120 des Substrats 100 und zumindest Abschnitte der Seitenwände 112, die an den Boden 114 grenzen, mit einer Resist-Schicht 130, 131 bedeckt. Sollten noch Abschnitte der Seitenwände 112 der Vertiefung 110 nicht mit einer Resist-Schicht bedeckt sein, geschieht dieses erfindungsgemäß durch nochmaliges Auftragen (z. B. durch Sprühbeschichtung) einer Resist-Lösung auf die Oberfläche des Substrats 100. Dabei werden auch (eventuell nach erneutem Erwärmen des Substrats) die vorher noch nicht bedeckten oberen Abschnitte der Seitenwände 112 mit Resist beschichtet.

Somit kann eine Vertiefung in einem Substrat mit einem Resist durchgängig und gleichmäßig beschichtet werden.

In einer weiteren Alternative, die nicht zur Erfindung gehört, wird eine Resist-Lösung auf die Oberfläche 120 des Substrats 100 aufgebracht und gleichzeitig in die Vertiefung 110 eingefüllt. Das Erwärmen des Substrats 100 kann durch eine Wärmequelle 160 erfolgen, und schließlich sind der Boden 114 der Vertiefung 110, die Oberfläche 120 des Substrats 100 und die Seitenwände 112 komplett mit einer durchgängigen, gleichmäßigen Resist-Schicht 130, 131 bedeckt.

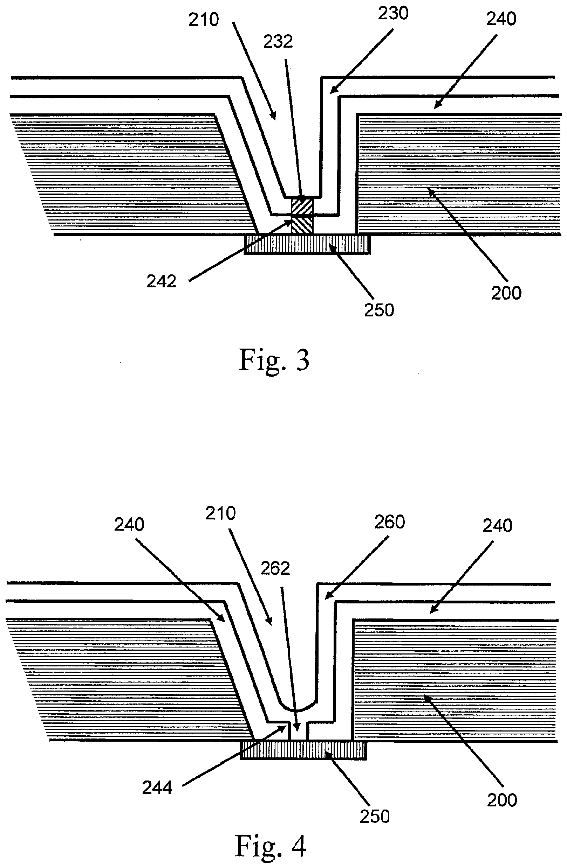

Figur 3 zeigt beispielhaft eine Seitenansicht eines Substrats 200 mit einem Durchgangsloch 210. Das Substrat und das Durchgangsloch weisen eine Dielektrikum-Schicht 240 auf, auf die eine Resist-Schicht 230 nach einem der oben beschriebenen Verfahren aufgebracht wurde. Als Boden funktioniert in diesem Fall eine Kontaktstruktur 250. An diesem Substrat wird im Folgenden ein lithographisches Verfahren durchgeführt, um durch das Durchgangsloch 210 eine Kontaktierung zu ermöglichen. Hierzu wird die Resist-Schicht 230 belichtet und entwickelt, so dass der Abschnitt 232 der Resist-Schicht 230 entfernt werden kann. Anschließend wird der Abschnitt 242 der Dielektrikum-Schicht durch Ätzen aus der Schicht gelöst. Die restliche Resist-Schicht 230 wird dann mit einem Lösungsmittel entfernt.

Wie man anhand von Figur 4 sieht, kann, nachdem die Resist-Schicht 230 entfernt wurde, eine Metall-Schicht 260 (z. B. aus Aluminium) auf die Dielektrikum-Schicht 240 aufgebracht werden. Diese Metall-Schicht 260 kann dann eine Kontaktierung 262 zu der Kontaktstruktur 250 bewirken, da die Dielektrikum-Schicht an dem Abschnitt 244 durch den oben beschriebenen Ätzprozess unterbrochen wurde.

Auf diese Weise können sehr einfach Beschichtungen für Durchgangslöcher oder andere Vertiefungen in Substraten, wie Silizium-Wafern, für die Weiterverarbeitung zu z. B. mikroelektromechanischen Systemen realisiert werden.

## Patentansprüche

1. Verfahren zur Resist-Beschichtung der Innenfläche (112, 114) einer Vertiefung (110) in der Oberfläche (120) eines Substrats (100, 200) mit den Schritten:
a) Befüllen der Vertiefung (110) mit einer Resist-Lösung,
b) Erwärmen des Substrats (100, 200) derart, dass das Lösungsmittel der Resist-Lösung verdampft und der Boden (114) und zumindest Abschnitte der Innenwand (112) der Vertiefung (110), die an den Boden (114) grenzen, mit dem Resist beschichtet sind,
**gekennzeichnet durch**
c) nochmaliges Beschichten der Oberfläche (120) des Substrats (100) mit einem Resist derart, dass Resist-Lösung von der Oberfläche (120) in die Vertiefung (110) überfließt, sodass auch Abschnitte von Innenwänden (112) der Vertiefung (110), die an die Oberfläche (120) des Substrats (100, 200) grenzen und die nach den Schritten a) und b) noch nicht beschichtet sind, beschichtet werden,
wobei die Breite der Vertiefung 10 bis 100 µm beträgt.

2. Verfahren nach Anspruch 1, wobei das Beschichten der Oberfläche (120) des Substrats (100, 200) mit dem Resist durch Aufbringen einer Resist-Lösung erfolgt.

3. Verfahren nach Anspruch 2, wobei die Viskosität dieser Lösung gleich oder höher ist als die Viskosität der Resist-Lösung zum Befüllen der Vertiefung (110).

4. Verfahren nach Anspruch 1, 2 oder 3, wobei das Befüllen der Vertiefung (110) gleichzeitig mit dem Beschichten der Oberfläche (120) des Substrats (100, 200) mit der Resist-Lösung erfolgt.

5. Verfahren nach einem der vorangegangenen Ansprüche, wobei das Erwärmen des Substrats (100, 200) ein Erwärmen der Vertiefung (110) und optional der Oberfläche (120) bewirkt.

6. Verfahren nach einem der vorangegangenen Ansprüche, wobei nach den Schritten (a), (b) und (c) der Resist auf der Innenwand (112, 114) der Vertiefung (110) eine durchgängige Schicht bildet.

7. Verfahren nach einem der vorangegangenen Ansprüche, wobei das Befüllen der Vertiefung (110) des Substrats (100, 200) durch Sprühbeschichtung erfolgt.

8. Verfahren nach einem der vorangegangenen Ansprüche, wobei das Volumen der eingefüllten Lösung kleiner ist als das Volumen der Vertiefung (110) oder diesem gleicht.

9. Verfahren nach einem der vorangegangenen Ansprüche, wobei die Vertiefung (110) ein Durchgangsloch (210) durch das Substrat (200) ist und das Substrat (100, 200) an seiner Unterseite, die seiner Oberfläche (120) gegenüberliegt, einen Träger aufweist, der das Durchgangsloch (210) an dieser Seite als Boden verschließt.

10. Verfahren nach Anspruch 9, wobei nach den Schritten (a), (b) und (c), folgender Schritt vorgesehen ist:
d) Entfernen des Trägers.

11. Verfahren nach Anspruch 10, mit dem folgenden Schritt (e) nach dem Schritt (d):
e) Beschichtung der Unterseite des Substrats (200) mit einem Resist derart, dass auch Abschnitte von Innenwänden des Durchgangslochs (210), die der Unterseite des Substrats (200) am nächsten liegen, beschichtet werden,

12. Verfahren nach Anspruch 11, wobei nach den Schritten (a), (b), (c), (d) und (e), der Resist in dem Durchgangsloch (210) und an der Oberfläche (120) und der Unterseite des Substrats (200) eine durchgängige Schicht bildet.

13. Verfahren nach einem der vorangegangen Ansprüche, wobei das Substrat (200) auf seiner Oberfläche (120) und in der Vertiefung eine Dielektrikum-Schicht (240) aufweist, auf der die Resist-Beschichtung durchgeführt wird.

14. Verfahren nach einem der vorangegangenen Ansprüche, wobei das Verhältnis der größten Tiefe der Vertiefung (110), senkrecht zur Substratoberfläche gemessen, zur größten Breite der Vertiefung (110), parallel zur Substratoberfläche gemessen, gleich 2:1 oder größer ist.

15. Verfahren nach einem der vorangegangenen Ansprüche, wobei die größte Tiefe der Vertiefung (110), senkrecht zur Substratoberfläche (120) gemessen, zwischen 20 µm und 300 µm beträgt.

16. Verfahren nach einem der vorangegangenen Ansprüche, wobei die Dicke der Resist-Schicht in der Vertiefung (110) des Substrats (100, 200) mindestens 0,5 µm, vorzugsweise mindestens 0,8 µm, beträgt.

## Claims

1. A method of resist coating the inner surface (112, 114) of a depression (110) in the surface (120) of a substrate (100, 200), comprising the steps of:
(a) filling the depression (110) with a resist solution,
(b) heating the substrate (100, 200) such that the solvent of the resist solution vaporizes and the bottom (114) and at least portions of the inner wall (112) of the depression (110) that are adjacent to the bottom (114) are coated with the resist,
**characterized by**
(c) coating the surface (120) of the substrate (100) with a resist again such that resist solution overflows from the surface (120) into the depression (110), so that sections of inner walls (112) of the depression (110) that are adjacent to the surface (120) of the substrate (100, 200) and that are not yet coated after steps (a) and (b) are also coated,
the width of the depression being from 10 to 100 µm.

2. The method according to claim 1, wherein the surface (120) of the substrate (100, 200) is coated with the resist by applying a resist solution.

3. The method according to claim 2, wherein the viscosity of this solution is equal to or higher than the viscosity of the resist solution for filling the depression (110).

4. The method according to claim 1, 2 or 3, wherein the filling of the depression (110) is effected simultaneously with the coating of the surface (120) of the substrate (100, 200) with the resist solution.

5. The method according to any of the preceding claims, wherein heating the substrate (100, 200) causes a heating of the depression (110) and optionally of the surface (120).

6. The method according to any of the preceding claims, wherein after steps (a), (b) and (c), the resist forms a continuous layer on the inner wall (112, 114) of the depression (110).

7. The method according to any of the preceding claims, wherein the depression (110) of the substrate (100, 200) is filled by spray coating.

8. The method according to any of the preceding claims, wherein the volume of the solution filled in is smaller than or equals the volume of the depression (110).

9. The method according to any of the preceding claims, wherein the depression (110) is a via (210) through the substrate (200), and the substrate (100, 200) includes a carrier on its lower side opposite to its surface (120), the carrier closing the via (210) as a bottom on this side.

10. The method according to claim 9, wherein after steps (a), (b) and (c), the following step is provided:
(d) removing the carrier.

11. The method according to claim 10, comprising the following step (e) after step (d):
(e) coating the lower side of the substrate (200) with a resist such that portions of inner walls of the via (210) that are nearest to the lower side of the substrate (200) are also coated.

12. The method according to claim 11, wherein after steps (a), (b), (c), (d) and (e), the resist forms a continuous layer in the via (210) and on the surface (120) and the lower side of the substrate (200).

13. The method according to any of the preceding claims, wherein the substrate (200) includes a dielectric layer (240) on its surface (120) and in the depression, the resist coating being performed on the dielectric layer.

14. The method according to any of the preceding claims, wherein the ratio of the greatest depth of the depression (110), as measured perpendicular to the substrate surface, to the greatest width of the depression (110), as measured parallel to the substrate surface, is equal to or greater than 2:1.

15. The method according to any of the preceding claims, wherein the greatest depth of the depression (110), as measured perpendicular to the substrate surface (120), is between 20 µm and 300 µm.

16. The method according to any of the preceding claims, wherein the thickness of the resist layer in the depression (110) of the substrate (100, 200) is at least 0.5 µm, preferably at least 0.8 µm.

## Revendications

1. Procédé de revêtement de résist de la face intérieure (112, 114) d'un évidement (110) dans la surface (120) d'un substrat (100, 200), comprenant les étapes suivantes :
a) remplissage de l'évidement (110) d'une solution de résist,
b) échauffement du substrat (100, 200) de telle sorte que le solvant de la solution de résist s'évapore et le fond (114) et au moins des tronçons de la paroi intérieure (112) de l'évidement (110) adjacents au fond (114) sont recouverts du résist,
**caractérisé par**
c) un nouveau revêtement de la surface (120) du substrat (100) d'un résist de telle sorte que de la solution de résist s'écoule de la surface (120) dans l'évidement (110), de sorte que des tronçons de parois intérieures (112) de l'évidement (110) qui sont adjacents à la surface (120) du substrat (100, 200) et ne sont pas encore revêtus après les étapes a) et b) sont également revêtus,
la largeur de l'évidement étant comprise entre 10 et 100 µm

2. Procédé selon la revendication 1, le revêtement de la surface (120) du substrat (100, 200) du résist étant réalisé par application d'une solution de résist.

3. Procédé selon la revendication 2, la viscosité de cette solution étant égale ou supérieure à la viscosité de la solution de résist pour le remplissage de l'évidement (110).

4. Procédé selon la revendication 1, 2 ou 3, le remplissage de l'évidement (110) étant réalisé simultanément au revêtement de la surface (120) du substrat (100, 200) de la solution de résist.

5. Procédé selon l'une des revendications précédentes, l'échauffement du substrat (100, 200) provoquant un échauffement de l'évidement (110) et facultativement de la surface (120).

6. Procédé selon l'une des revendications précédentes, le résist formant sur la paroi intérieure (112, 114) de l'évidement (110) une couche continue après les étapes (a), (b) et (c).

7. Procédé selon l'une des revendications précédentes, le remplissage de l'évidement (110) du substrat (100, 200) étant réalisé par revêtement par pulvérisation.

8. Procédé selon l'une des revendications précédentes, le volume de la solution remplie étant inférieur ou égal au volume de l'évidement (110).

9. Procédé selon l'une des revendications précédentes, l'évidement (110) étant un trou de passage (210) à travers le substrat (200), et le substrat (100, 200) présentant sur face inférieure opposée à sa surface (120) un support qui obture le trou de passage (210) de ce côté en tant que fond.

10. Procédé selon la revendication 9, l'étape suivante étant prévue après les étapes (a), (b), (c) :
d) retrait du support.

11. Procédé selon la revendication 10, comprenant après l'étape (d) l'étape (e) suivante :
e) revêtement de la face inférieure du substrat (200) d'un résist de telle sorte que des tronçons de parois intérieures du trou de passage (210) qui sont les plus proches de la face inférieure du substrat (200) sont également revêtus.

12. Procédé selon la revendication 11, le résist formant une couche continue dans le trou de passage (210) et sur la surface (120) et la face inférieure du substrat (200) après les étapes (a), (b), (c), (d) et (e).

13. Procédé selon l'une des revendications précédentes, le substrat (200) présentant sur sa surface (120) et dans l'évidement une couche de diélectrique (240) sur laquelle le revêtement de résist est réalisé.

14. Procédé selon l'une des revendications précédentes, le rapport de la plus grande profondeur de l'évidement (110), mesurée perpendiculairement à la surface du substrat, par rapport à la plus grande largeur de l'évidement (110), mesurée parallèlement à la surface du substrat, étant égal ou supérieur à 2:1.

15. Procédé selon l'une des revendications précédentes, la plus grande profondeur de l'évidement (110), mesurée perpendiculairement à la surface (120) du substrat, étant comprise entre 20 µm et 300 µm.

16. Procédé selon l'une des revendications précédentes, l'épaisseur de la couche de résist dans l'évidement (110) du substrat (100, 200) étant égale à au moins 0,5 µm, de préférence à au moins 0,8 µm.
